# EUROPEAN PATENT SPECIFICATION

(11) **EP 1 401 251 B1**
(45) Date of publication and mention of the grant of the patent: **30.11.2005**
(21) Application number: 03255558.3
(22) Date of filing: 05.09.2003
(51) Int. Cl.: H05K 7/10, H01R 12/04, H01R 12/22, H01R 13/24

(54) **LGA socket contact**
LGA-Buchsenkontakt
LGA-Contact à douille

(30) Priority: 12.09.2002 JP 2002267103; 07.07.2003 JP 2003193009
(43) Date of publication of application: 24.03.2004
(73) Proprietor: Tyco Electronics AMP K.K., Kawasaki-shi, Kanagawa 213-8535 (JP)
(72) Inventor: Shirai, Hiroshi, Tokorozawa-shi Saitama-ken 359-0021 (JP); Taguchi, Hidenori, Kawasaki-shi Kanagawa-ken 215-0021 (JP); Hashimoto, Shinichi, Kawasaki-shi Kanagawa-ken 213-0013 (JP)
(74) Representative: Johnstone, Douglas Ian

(56) References cited:
- US-A- 4 857 001
- US-A- 5 688 140
- US-A- 6 164 978
- US-A1- 2002 111 052
- US-B1- 6 299 492

## Description

### BACKGROUND OF THE INVENTION

### Field of the Invention

The present invention relates to an LGA (land grid array) socket contact which is used in an LGA socket.

### Description of the Related Art

LGA sockets are used to connect circuit boards with IC sockets that have a plurality of contact pads on the bottom surface. Conventionally, for example, the contact shown in Figs. 7 and 8 has been known as a contact used in such LGA sockets (see U.S. Patent No. 5984693).

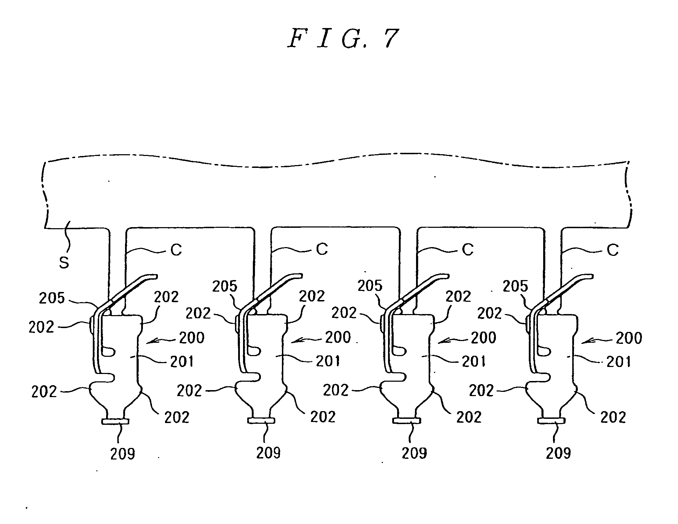

As is shown in Fig. 7, this contact 100 has a substantially rectangular base plate part 101, and is formed by stamping and forming a metal plate. Furthermore, guide projections 102 that protrude upward are formed on both ends of the upper edge 103 of the base plate part 101, and engaging pins 104 that protrude downward are formed on both ends of the lower edge of the base plate part 101. Moreover, two anchoring projections 105 are formed in positions that are separated by a specified distance in the vertical direction on each of the two side walls of the base plate part 101. Furthermore, an elastic C-shaped engaging part 106 which extends from between the engaging pins 104 and is bent so that this part is folded back in the upward direction is formed on the lower edge of the base plate part 101. A contact plate part 107 which is bent so that this part extends upward from the tip end of the elastic C-shaped engaging part 106 is formed on the tip end of this engaging part 106. The contact plate part 107 is separated by a specified distance from an inclined surface 103a formed between the guide projections 102 on the upper edge 103 of the base plate part 101, and the contact plate part 107 is caused to contact the inclined surface 103a by the application of an external force to the contact plate part 107 in the downward direction.

The contact 100 shown in Fig. 7 is accommodated inside the contact accommodating space 111 of a housing 110 as shown in Fig. 8. As a result, the LGA socket 120 is completed. When the contact 100 is accommodated in the contact accommodating space 111, the anchoring projections 105 of the contact 100 are anchored to the housing walls, and the contact plate part 107 protrudes upward beyond the upper surface of the housing 110, while the engaging pins 104 protrude downward beyond the undersurface of the housing 110.

Furthermore, as is shown in Fig. 8, the LGA socket 120 is clamped between an IC package 130 and a circuit board 140. In this clamped state, the engaging pins 104 contact contact pad 141 formed on the surface of the circuit board 140, and a contact pad 131 formed on the IC package 130 pushes the contact plate part 107 downward so that the contact plate part 107 contacts the inclined surface 103a. As a result of the contact between the contact plate part 107 and the inclined surface 103a, an electrical short-circuiting path is formed between the contact plate part 107 and the engaging pins 104, so that the contact pad 131 of the IC package 130 and the contact pad 141 of the circuit board 140 are electrically connected to each other.

However, in the case of such a conventional LGA socket contact 100, the engaging pins 104 are caused to contact the contact pad 141 of the circuit board 140, so that this contact 100 is unsuitable for use in applications in which the engaging pins 104 and contact pad 141 are connected by soldering.

Furthermore, when the contact pad 131 formed on the IC package 130 contacts the contact plate part 107, the contact pad 131 contacts the cut surface of the contact plate part 107 that is formed when the contact 100 is stamped; accordingly, the stability of this contact is poor.

For example, the contact shown in Fig. 9 has been developed as an LGA socket contact which solves these problems.

This contact 200 has a substantially rectangular base plate part 201, and is formed by stamping and forming a metal plate. Furthermore, two anchoring projections 202 are formed so that these projections are separated by a specified distance in the vertical direction on each of the two side walls of the base plate part 201. Moreover, a cut-out 203 is formed between the anchoring projections 202 of one side wall of the base plate part 201, and an elastic contact part 205 is formed via an L-shaped base part 204 which is bent approximately 90° from this cut-out 203. This elastic contact part 205 comprises a first elastic plate part 206 which extends upward from the tip end of the L-shaped base part 204, and a second elastic plate part 207 which extends upward at an inclination toward the opposite anchoring projection 202 from the upper end of the first elastic plate part 206. The direction of extension of the plate surface of the first elastic plate part 206 is perpendicular to the direction of extension of the plate surface of the base plate part 201, and the direction of extension of the plate surface of the second elastic plate part 207 is also perpendicular to the direction of extension of the plate surface of the base plate part 201. Furthermore, a contact part 208 which contacts a contact pad formed on the IC package (not shown in the figures) with a rolled surface is formed on the tip end of the second elastic plate part 207. Since the contact part 208 contacts the contact pad of the IC package with a rolled surface, the contact stability is good. Furthermore, a solder ball attachment paddle 209 which extends in a direction perpendicular to the base plate part 201 via a connecting part 210 is disposed on the lower edge of the base plate part 201. A solder ball (not shown in the figures) is disposed on the undersurface of the solder ball attachment paddle 209, and the solder ball attachment paddle 209 is connected by soldering to a contact pad on a circuit board (not shown in the figures).

However, the following problems have been encountered in this conventional LGA socket contact 200.

Specifically, the first elastic plate part 206 of the elastic contact part 205 extends from the tip end of an L-shaped base part 204 which is bent approximately 90° from the base plate part 201, and the direction of extension of the plate surface of the first elastic plate part 206 is perpendicular to the direction of extension of the plate surface of the base plate part 201. Accordingly, the height H from the back surface of the base plate part 201 to the edge of the first elastic plate part 206, i.e., the height of the elastic contact part 205 in the direction perpendicular to the base plate part 201 in the vicinity of the root of the elastic contact part 205, is increased. As a result, in cases where the contact 200 is arranged in the direction perpendicular to the base plate part 201, the reduction of the arrangement pitch is severely restricted.

On the other hand, the width of the first elastic plate part 206 might be minimized in order to reduce the arrangement pitch in the direction perpendicular to the base plate part 201. If this is done, however, the amount of displacement of the elastic contact part 205 cannot be set at a large amount. The reason for this is that if the width of the first elastic plate part 206 is reduced, the first elastic plate part 206 will undergo plastic deformation in cases where even a small external force is applied to the contact part 208 in the downward direction.

Furthermore, if the width of the first elastic plate part 206 is reduced, the cross-sectional area of the first elastic plate part 206 is reduced, so that the connection resistance is increased.

A further prior art land grid array socket contact (on which the preamble of claim 1 is based) is disclosed in US Patent No 5688140. The contact comprises a base plate part with anchoring projections formed on side walls thereof, an elastic contact part which has a contact part on its tip end with a curved surface and a board connecting part which extends from a lower end of the base plate part.

### SUMMARY OF THE INVENTION

Accordingly, the present invention was devised in light of the problems described above. It is an object of the present invention to provide an LGA socket contact which makes it possible to minimize the size of the elastic contact part in the direction perpendicular to the base plate part in the vicinity of the root of this elastic contact part, so that the arrangement pitch in this direction can be reduced, and which allows a large amount of displacement of the elastic contact part so that the connection resistance can be minimized.
In order to solve the problems described above, the LGA socket contact of Claim 1 comprises a base plate part in which anchoring projections are formed on side walls thereof, an elastic contact part which has a contact part on its tip end for contacting a contact pad of integrated circuit (IC) package with a curved surface, and a board connecting part which extends from the lower end of the base plate part, and which is connected by soldering to a circuit board, characterised in that the elastic contact part extends via a bent part that is bent by approximately 180° from a side wall of the base plate part.

Furthermore, the LGA socket contact of claim 2 comprises the contact of Claim 1, wherein a taper part i.s disposed on an upper surface of the bent part, and the taper part drops continuously towards a root part of the part that is bent by approximately 180°.

### BRIEF DESCRIPTION OF THE DRAWINGS

Fig. 1 is a perspective view of a first embodiment of the LGA socket contact of the present invention;
Fig. 2 is a plan view showing a state in which the LGA socket contact shown in Fig. 1 is accommodated inside a contact accommodating space;
Fig. 3 shows a second embodiment of the LGA socket contact of the present invention, with Fig. 3(A) being a perspective view seen at an inclination from above on the side of the front surface, and Fig. 3 (B) being a perspective view seen at an inclination from above on the side of the back surface;

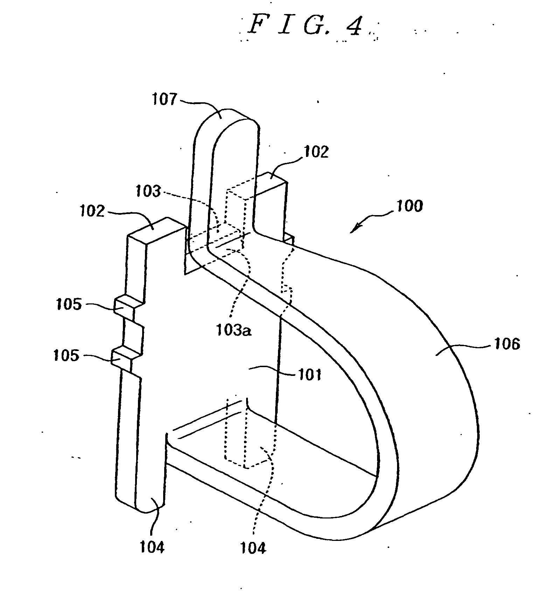

Fig. 4 is a perspective view of a conventional example of an LGA socket contact;

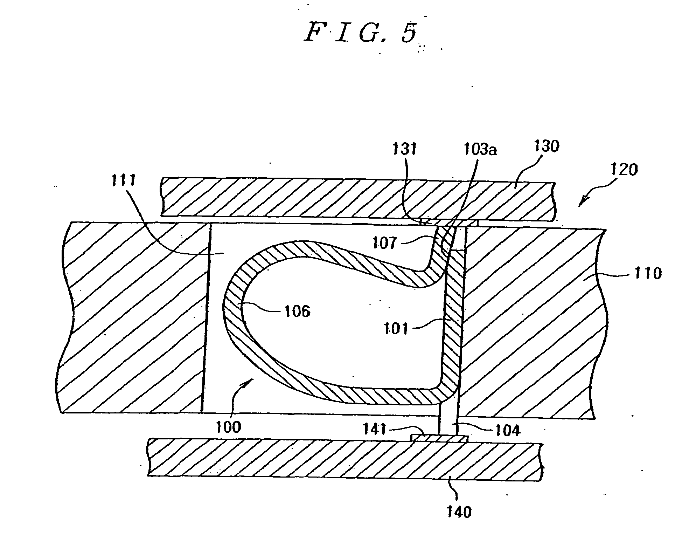

Fig. 5 is a sectional view showing a state in which the LGA socket contact shown in Fig. 4 is inserted into a housing;

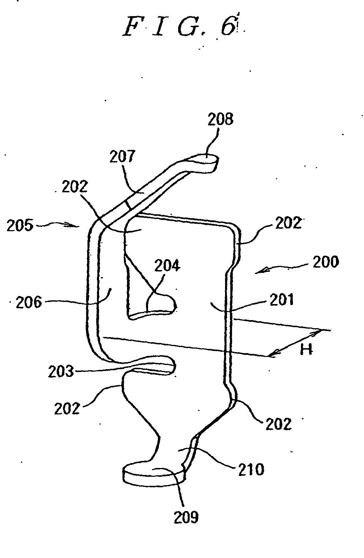

Fig. 6 is a perspective view of another conventional example of an LGA socket contact; and
Fig. 7 is an explanatory diagram showing a state in which the LGA socket contact shown in Fig. 6 is attached to a strip.

### DESCRIPTION OF THE PREFERRED EMBODIMENTS

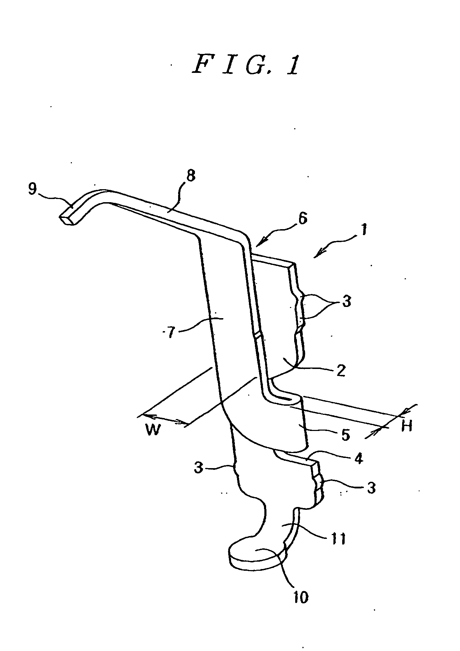

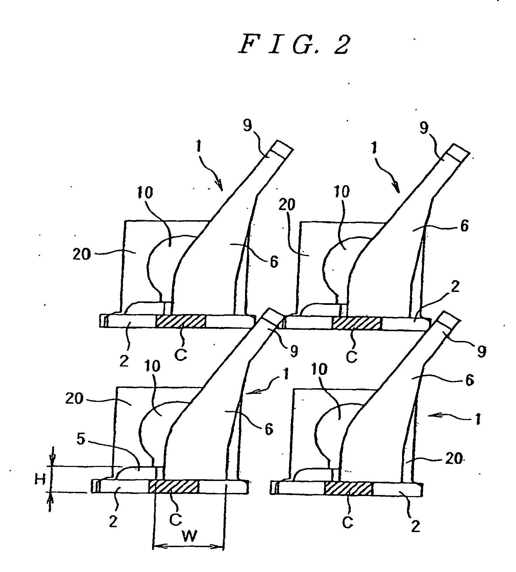

Embodiments of the present invention will be described below with reference to the figures. Fig. 1 is a perspective view of a first embodiment of the LGA socket contact of the present invention. Fig. 2 is a plan view showing a state in which the LGA socket contact shown in Fig.1 is accommodated in a contact accommodating space.

In Fig. 1, the LGA socket contact (hereafter referred to simply as a "contact") 1 of the first embodiment has a substantially rectangular base plate part 2, and is formed by stamping and forming a metal plate. Furthermore, a plurality of anchoring projections 3 (in the present embodiment, two on the upper part and one on the lower part) are formed on each of the two side walls of the base plate part 2 in positions that are separated by a specified gap in the vertical direction. Moreover, a cut-out 4 is formed in one side wall of the base plate part 2 between the anchoring projections 3 of the upper part and the anchoring projection 3 of the lower part. Furthermore, an elastic contact part 6 extends via a bent part 5 which is bent approximately 180° from this cut-out 4. This elastic contact part 6 has a first elastic plate part 7 which is bent upward from the tip of the bent part 5, and which extends upward, and a second elastic plate part 8 which is bent from the upper end of the first elastic plate part 7 in the direction that separates this second elastic plate part 8 from the base plate part 2, and which extends upward at an inclination. The direction of extension of the plate surface of the first elastic plate part 7 and the direction of extension of the plate surface of the base plate part 2 are parallel. Furthermore, a contact part 9 which contacts a contact pad formed on an IC package (not shown in the figures) with a rolled surface is formed on the tip end of the second elastic plate part 8. Since the contact part 9 contacts the contact pad of the IC package with a rolled surface, the contact stability is good. Furthermore, a solder ball attachment paddle (board connecting part) 10 which extends via a connecting part 11 in a direction perpendicular to the base plate part 2 is disposed on the lower edge of the base plate part 2. A solder ball (not shown in the figures) is disposed on the undersurface of the solder ball attachment paddle 10, and the solder ball attachment paddle 10 is connected by soldering to a contact pad on a circuit board (not shown in the figures).

In the contact 1, as is shown in Figs. 1 and 2, the height H of the bent part 5 and first elastic plate part 7 in the direction perpendicular to the base plate part 2 is substantially the same as twice the thickness of the metal plate that forms the contact 1, since the bent part 5 is bent approximately 180°. Accordingly, this height H is far smaller than the height H of the L-shaped base part 204 and first elastic plate part 206 of the contact 200 shown in Fig. 10. Consequently, the size of the contact 1 in the direction perpendicular to the base plate part 2 can be minimized, so that the arrangement pitch in this direction can be reduced. Furthermore, since the height H of the bent part 5 and first elastic plate part 7 in the direction perpendicular to the base plate part 2 can be reduced, the width W of the first elastic plate part 7 can be maximized. In the present embodiment, the width W of the first elastic plate part 7 is substantially the same as the width of the bent part 5.

The contact 1 shown in Fig. 1 is accommodated inside the contact accommodating spaces 20 of a housing (not shown in the figures) as shown in Fig. 2. The contact accommodating spaces 20 are disposed in the housing in a plurality of rows so as to correspond to the contact pads of an IC package, and a plurality of contacts 1 are accommodated inside the contact accommodating spaces 20. As a result, the LGA socket is completed. When the contacts 1 are accommodated in the contact accommodating spaces 20, the anchoring projections 3 of the contacts 1 are anchored to the housing walls; furthermore, the second contact plate parts 8 of the respective contacts protrude upward beyond the upper surface of the housing, and the solder ball attachment paddles 10 on which solder balls are disposed protrude downward beyond the undersurface of the housing. Here, the anchoring projections 3 are formed on the upper and lower parts of the side walls of each base plate part 2, and the elastic contact part 6 of each contact 1 extends from between these anchoring projections 3; accordingly, the span between the anchoring projections 3 is long, and when the anchoring projections 3 are anchored to the housing walls, the contact part 9 formed on the tip end of each elastic contact part 6 can be positioned with good precision.

Furthermore, this LGA socket is mounted on a circuit board by connecting (by soldering) the solder balls disposed on the solder ball attachment paddles 10 to contact pads on the circuit board. In this state, when the IC package is mounted on the LGA socket from above, the contact pads disposed on the IC package contact the contact parts 9 of the respective contacts 1, and push these contact parts 9 downward, so that the second elastic plate part 8 and first elastic plate part 7 of each contact 1 undergo elastic deformation. As a result, the contact pads of the IC package and the contact pads of the circuit board are electrically connected to each other. When the first elastic plate parts 7 undergo deformation, since the width W of the first elastic plate parts 7 can be maximized as described above, there is no plastic deformation of the first elastic plate parts 7 even in cases where a large external force acts on the contact parts 9 in a downward direction. Accordingly, the amount of displacement of the elastic contact parts 6 can be increased to a large value.

Furthermore, since the width W of the first elastic plate parts 7 can be increased to a large value, the cross-sectional area of the first elastic plate parts 7 can be increased, so that the contact resistance can be reduced

On the other hand, the contacts 1 shown in Fig. 1 are accommodated inside a plurality of rows of contact accommodating spaces 20 in the housing as shown in Fig. 2. In the accommodated state, the elastic contact parts 6 of the contacts 1 accommodated in one row are not located in positions that overlap with the contact carriers C of the contacts 1 accommodated in an adjacent row Accordingly, when the contacts 1 are accommodated in the contact accommodating spaces 20, this accommodation is accomplished as follows : specifically, the contact carriers C of the respective contacts 1 are cut after both the plurality of contacts 1 of one row and the plurality of contacts 1 of the adjacent row have been inserted into the contact accommodating spaces 20. Accordingly, the following merit is obtained: namely, the accommodation of the contacts 1 shown in Fig. 1 in the contact accommodating spaces 20 can be accomplished easily

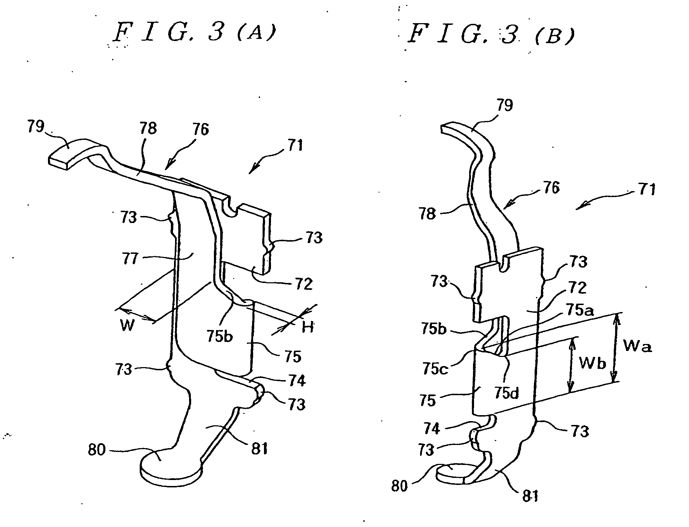

Next, a second embodiment of the LGA socket contact of the present invention will be described with reference to Fig- 3 . Fig. 3 shows a second embodiment of the LGA socket contact of the present invention; Fig. 3 (A) is a perspective view seen at an inclination from above on the side of the front surface, and Fig. 3 (B) is a perspective view seen at an inclination from above on the side of the back surface.

In Fig. 3, the contact 71 of the second embodiment has the same basic structure as the contact 1 shown in Fig. 1; however, this contact 71 differs from the contact 1 in that a taper part 75a which drops continuously toward the root portion 75d from the portion 75c that is bent approximately 180° is formed on the upper surface of the bent part 75 on the side of the base plate part 72, and in that a taper part 75b which rises continuously toward the side wall of the first elastic plate part 77 from the portion 75c that is bent approximately 180° is formed on the upper surface of the bent part 75 on the side of the elastic contact part 76.

Specifically, the contact 71 has a substantially rectangular base plate part 72, and is formed by stamping and forming a metal plate. Furthermore, a plurality of anchoring projections 73 are formed on each of the two side walls of the base plate part 72 in positions that are separated by a specified gap in the vertical direction. Moreover, a cut-out 74 is formed in one of the side walls of the base plate part 72 between the upper and lower anchoring projections 73. Furthermore, the elastic contact part 76 extends from this cut-out 74 via the bent part 75 that is bent approximately 180°.

This elastic contact part 76 has a first elastic plate part 77 which is bent upward from the tip end of the bent part 75, and which extends upward, and a second elastic plate part 78 which is bent from the upper end of the first elastic plate part 77 in the direction that separates this elastic plate part 78 from the base plate part 72, and which extends upward at an inclination. The direction of extension of the plate surface of the first elastic plate part 77 and the direction of extension of the plate surface of the base plate part 72 are parallel.

Furthermore, as was described above, a taper part 75a which drops continuously toward the root portion 75d from the portion 75c that is bent approximately 180° is formed on the upper surface of the bent part 75 on the side of the base plate part 72, and a taper part 75b which rises continuously toward the side wall of the first elastic plate part 77 of the elastic contact part 76 from the portion 75c that is bent approximately 180° is formed on the upper surface of the bent part 75 on the side of the elastic contact part 76. As a result of the formation of this taper part 75a which drops continuously toward the root portion 75d from the portion 75c that is bent approximately 180° on the upper surface of the bent part 75 on the side of the base plate part 72, the width (in the vertical direction) of the bent part 75 on the side of the base plate part 72 decreases continuously from Wa to Wb toward the root portion 75d from the portion 75c that is bent approximately 180° as shown in Fig. 3 (B). Furthermore, as a result of the formation of the taper part 75b which rises continuously toward the side wall of the first elastic plate part 77 of the elastic contact part 76 from the portion 75c that is bent approximately 180° on the upper surface of the bent part 75 on the side of the elastic contact part 76, the width (in the vertical direction) of the bent part 75 own the side of the elastic contact part 76 increases continuously toward the first elastic plate part 77 from the portion 75c that is bent approximately 180°.

Furthermore, a contact part 79 which contacts a contact pad formed on an IC package (not shown in the figures) with a rolled surface is formed on the tip end of the second elastic plate part 78. Since the contact part 79 contacts the contact pad of the IC package with a rolled surface, the contact stability is good. Moreover, a solder ball attachment paddle (board connecting part) 80 which extends via a connecting part 81 in a direction perpendicular to the base plate part 72 is disposed on the lower edge of the base plate part 72. A solder ball (not shown in the figures) is disposed on the undersurface of the solder ball attachment paddle 80, and the solder ball attachment paddle 80 is connected by soldering to a contact pad on a circuit board (not shown in the figures).

In the contact 71, the height H of the bent part 75 and first elastic plate part 77 in the direction perpendicular to the base plate part 72 is substantially the same as twice the thickness of the metal plate that forms the contact 71, since the bent part 75 is bent approximately 180° in the same manner as in the contact 1 shown in Fig. Accordingly, this height H is far smaller than the height H of the L-shaped base part 204 and first elastic plate part 206 of the contact 200 shown in Fig. 9. Consequently, the size of the contact 71 in the direction perpendicular to the base plate part 72 can be minimized, so that the arrangement pitch in this direction can be reduced. Furthermore, since the height H of the bent part 75 and first elastic plate part 77 in the direction perpendicular to the base plate part 72 can be reduced, the width W of the first elastic plate part 77 can be maximized. Accordingly, the cross-sectional area of the first elastic plate part 77 can be increased, so that the connection resistance can be reduced.

Furthermore, since the width (in the vertical direction) of the bent part 75 on the side of the base plate part 72 decreases continuously from Wa to Wb toward the root portion 75d from the portion 75c that is bent approximately 180°, the region in which the elastic contact part 76 can act as a spring is expanded to the root portion 75d of the bent part 75 compared to the contact 1 shown in Fig. 1. Meanwhile, since the width (in the vertical direction) of the bent part 75 on the side of the elastic contact part 76 increases continuously toward the first elastic plate part 77 from the portion 75c that is bent approximately 180°, the cross-sectional area of the bent part 75 on the side of the elastic contact part 76 can be increased compared to the contact 1 shown in Fig. 1, so that a current path with a relatively large cross-sectional area can be ensured.

Embodiments of the present invention have been described above. However, the present invention is not limited to these embodiments; various alterations and modifications are possible.

For example, in the contact 1 shown in Fig. 1, the elastic contact part 6 extends via a bent part 5 from a cut-out 4 formed between the upper and lower anchoring projections 3. However, it would also be possible for this elastic contact part 6 to extend via the bent part 5 from the side wall of the base plate part 2 between the upper and lower anchoring projections 3, without forming a cut-out 4. Furthermore, if the elastic contact part 6 extends via such a bent part 5 from the side wall of the base plate part 2 on which anchoring projections 3 are formed, it is not absolutely necessary that this elastic contact part 6 extend from between the upper and lower anchoring projections 3.

As was described above, the LGA socket contact of Claim 1 of the present application comprises a base plate part in which anchoring projections are formed on side walls thereof, an elastic contact part which has a contact part on its tip end for contacting a contact pad of an IC package with a curved surface, and a board connecting part which extends from the lower end of the base plate part, and which is connectable by soldering to a circuit board characterised in that the elastic part extends via a bent part that is bent by approximately 180 from a side wall of the base plate part. Accordingly, the height of the elastic contact part in the direction perpendicular to the base plate part in the vicinity of the root portion of the elastic contact part is substantially the same as twice the thickness of the metal plate that forms the contact. Thus, this height can be reduced, so that the height in the direction perpendicular to the base plate part can be minimized, thus making it possible to reduce the arrangement pitch in this direction. Moreover, the width of the elastic contact part can be maximized, and the amount of displacement of the elastic contact part can be increased. Furthermore, since the width of the elastic contact part can be increased, a current path with a relatively large cross-sectional area can be ensured, so that the connection resistance can be reduced.

Accordingly, the region in which the elastic contact part can act as a spring can be expanded to the root portion of the bent part while ensuring a current path with a relatively large cross-sectional area.

Furthermore, the LGA socket contact of Claim 2 comprises the contact of Claim 1, wherein a taper part is disposed on an upper surface of the bent part and the taper part drops continuously toward a root part of the part that is bent by approximately 180°.

## Claims

1. A land grid array (LGA) socket contact (1) comprising a base plate part (2) in which anchoring projections (3) are formed on side walls thereof, an elastic contact part (6) which has a contact part (9) on its tip end for contacting a contact pad of an integrated circuit (IC) package with a curved surface, and a board connecting part (11) which extends from a lower end of the base plate part (2), and which is connectable by soldering to a circuit board, **characterised in that** the elastic contact part (6) extends via a bent part (5) that is bent by approximately 180° from a side wall of the base plate part (2).

2. A land grid array (LGA) socket contact (71) according to claim 1, wherein taper part (75a, 75b) is disposed on an upper surface of the bent part (75) and the taper part (75a, 75b) drops continuously towards a root part (75d) of the part that is bent by approximately 180°.

## Patentansprüche

1. Steggittermatrix-(LGA - land grid array)-Buchsenkontakt (1), der einen Grundplattenteil (2), in dem an Seitenwänden desselben Verankerungsvorsprünge (3) geformt sind, einen elastischen Kontaktteil (6), der an seinem Spitzenende einen Kontaktteil (9) zum Berühren einer Kontaktinsel eines Gehäuses eines integrierten Schaltkreises (IC) mit einer gekrümmten Oberfläche hat, und einen Platinenverbindungsteil (11) umfaßt, der sich von einem unteren Ende des Grundplattenteils (2) erstreckt und der durch Löten mit einer Leiterplatte verbunden werden kann, **dadurch gekennzeichnet, daß** sich der elastische Kontaktteil (6) über einen gebogenen Teil (5) erstreckt, der um ungefähr 180° von einer Seitenwand des Grundplattenteils (2) gebogen ist.

2. Steggittermatrix- (LGA) Buchsenkontakt (71) nach Anspruch 1, wobei an einer oberen Fläche des gebogenen Teils (75) ein Verjüngungsteil (75a, 75b) angeordnet ist und der Verjüngungsteil (75a, 75b) fortlaufend zu einem Fußteil (75d) des Teils hin abfällt, der um ungefähr 180° gebogen ist.

## Revendications

1. Contact à douille en grille matricielle (LGA) (1) comprenant une partie formant plaque de base (2) dans laquelle des saillies d'ancrage (3) sont formée sur ses parois latérales, une partie de contact élastique (6) qui possède une partie de contact (9) sur son extrémité de pointe pour entrer en contact avec un plot de contact d'un boîtier de circuit intégré (CI) présentant une surface incurvée, et une partie de connexion de carte (11) qui s'étend depuis une extrémité inférieure de la partie formant plaque de base (2) et qui peut être reliée par brasage à une carte à circuit, **caractérisé en ce que** la partie de contact élastique (6) s'étend via une partie recourbée (5) qui est recourbée à approximativement 180° par rapport à une paroi latérale de la partie formant plaque de base (2).

2. Contact à douille en grille matricielle (LGA) (71) selon la revendication 1, dans lequel une partie d'effilement (75a, 75b) est disposée sur une surface supérieure de la partie recourbée (75) et la partie d'effilement (75a, 75b) descend de façon continue vers une partie d'empattement (75d) de la partie qui est recourbée à approximativement 180°.
